# EUROPÄISCHE PATENTSCHRIFT

(11) **EP 2 211 598 B1**
(45) Veröffentlichungstag und Bekanntmachung des Hinweises auf die Patenterteilung: **15.07.2020**
(21) Anmeldenummer: 09177707.8
(22) Anmeldetag: 02.12.2009
(51) Int. Cl.: H05K 3/28, H05K 3/34, H01L 23/495, H01R 4/02

(54) **Verfahren zur Herstellung eines Sensormoduls**
Method for making a sensor module
Procédé de fabrication d'un module de capteur

(30) Priorität: 27.01.2009 DE 102009000427
(43) Veröffentlichungstag der Anmeldung: 28.07.2010
(73) Patentinhaber: Robert Bosch GmbH, 70442 Stuttgart (DE)
(72) Erfinder: Mueller, Jochen, 71277, Rutesheim-Perouse (DE); Miessner, Ralf, 71634, Ludwigsburg (DE); Peter, Erik, 71636, Ludwigsburg (DE); Gerhaeusser, Martin, 74336, Brackenheim-Stockheim (DE)

(56) Entgegenhaltungen:
- EP-A2- 0 566 043
- DE-A1-102007 028 512
- DE-B3-102006 047 187
- JP-A- 2005 183 430
- JP-U- S6 310 582
- US-A- 5 929 511
- US-A1- 2002 153 582
- US-B1- 6 307 749

## Beschreibung

### Stand der Technik

In verschiedenen Bereichen der Naturwissenschaften, der Technik und der Medizin werden Sensormodule eingesetzt, welche mindestens ein Sensorelement zur Erfassung mindestens einer physikalischen und/oder chemischen Größe aufweisen. Die folgende Erfindung wird insbesondere unter Bezugnahme auf Sensormodule für den Einsatz in Getriebesteuerungen eines Kraftfahrzeugs beschrieben, ist jedoch grundsätzlich auch für andere Einsatzgebiete verwendbar. Insbesondere kann die Erfindung für Sensormodule eingesetzt werden, bei denen eine erhöhte Anforderung hinsichtlich der Medienbeständigkeit besteht, beispielsweise allgemein Sensormodulen im Kraftfahrzeugbereich, beispielsweise im Bereich von Kraftstoffsensoren für Benzin und/oder Dieselöl, und/oder für Batteriesäuresensoren. Auch andere Einsatzgebiete sind denkbar.

In vielen Automatikgetrieben werden in der Getriebesteuerung Positionssensoren eingesetzt, welche die Stellungen eines Stellgliedes innerhalb des Automatikgetriebes erfassen. Derartige Positionssensoren werden beispielsweise in der Veröffentlichung "Elektronische Getriebesteuerung EGS", Robert Bosch GmbH, Ausgabe 2004, Seite 60 beschrieben. Für einen möglichen Aufbau und eine Arbeitsweise derartige Positionssensoren, die auch im Rahmen der vorliegenden Erfindung erfindungsgemäß modifiziert werden können, kann zumindest weitgehend auf diese Veröffentlichung verwiesen werden. Positionssensoren für Getriebesteuerungen, beispielsweise die oben beschriebenen, bekannten Positionssensoren, weisen in der Regel mindestens ein Sensorelement auf, welches in der Lage ist, mindestens eine physikalische und/oder chemische Messgröße zu erfassen. Insbesondere werden in Positionssensoren vorverpackte Hall-Sensoren eingesetzt, beispielsweise in Form von integrierten Schaltkreisen (Hall-ICs). Beispielsweise können derartige Hall-ICs in Form von SOx-Gehäusen verwendet werden, welche beispielsweise gemeinsam mit passiven Bauelementen auf eine Leiterplatte aufgelötet sein können. Die Kontaktierung dieser Leiterplatte an ein Getriebemodul kann in der Regel durch angelötete Stanzgitter erfolgen. Die Leiterplatte mit den ankontaktierten Stanzgittern wird in der Regel in ein Thermoplastgehäuse eingelegt und mit einem Epoxidharz ausgegossen. Die Patentanmeldung DE 10 2007 028512 A1 offenbart ein Herstellungsverfahren für ein Sensormodul und das Sensormodul selbst entsprechend des Oberbegriffs der Ansprüche 1 und 9.

Positionssensoren sind, wie viele andere Sensormodule für den Einsatz in den Naturwissenschaften, der Technik und der Medizin auch, in vielen Fällen harten Umgebungsbedingungen ausgesetzt. So sind Positionssensoren beispielsweise in der Regel teilweise oder vollständig in Getriebeöl (automatic transmission fluid, ATF) angeordnet, insbesondere in verschmutztem Getriebeöl. Zudem sind derartige Positionssensoren den im Inneren des Getriebes vorherrschenden Umgebungsbedingungen ausgesetzt, beispielsweise Betriebstemperaturen von -40°C bis hin zu 150°C. Weiterhin sind derartige Positionssensoren auch erhöhten mechanischen Belastungen ausgesetzt, beispielsweise mechanischen Schockbelastungen. Durch die hohen Belastungen kann es jedoch in den Positionssensoren allgemein zu Schädigungen kommen. So kann es beispielsweise durch den im allgemeinen hohen Ausdehnungskoeffizienten der gießfähigen Epoxidharzmassen, in welche die Leiterplatte eingegossen wird, zu einer beschleunigten Zerrüttung von Lötstellen und zu Delamination bei Temperaturwechseln kommen.

Insgesamt wären also, insbesondere für die genannten Einsatzzwecke, Herstellverfahren, Sensormodule und die Sensormodule verwendende Schaltelemente wünschenswert, welche in verstärktem Maße auf die genannten Anforderungen eingehen. Insbesondere soll den erhöhten Dichtheitsanforderungen gegenüber aggressiven Medien, wie beispielsweise dem genannten ATF, Genüge geleistet werden, da beispielsweise in ein Gehäuse eindringendes ATF zu einer Korrosion von Leiterbahnen und/oder Bonddrähten und/oder sogar zu Kurzschlüssen führen kann. Insgesamt sollte also die Mediendichtheit erhöht werden, bei gleichzeitiger Gewährleistung der oben beschriebenen thermischen Anforderungen. Die Patentanmeldung US 5 929 511 A offenbart die Verwendung einer adhäsionsfördernden Ni/Pd/Au-Schicht auf einem Stanzgitter eines Halbleiterelements zur Erhöhung der Mediendichtheit am Übergang zwischen Stanzgitter und isolierender Umhüllung.

### Offenbarung der Erfindung

Zur Lösung der oben beschriebenen Aufgaben wird dementsprechend ein Verfahren zur Herstellung eines Sensormoduls vorgeschlagen, welches insbesondere für den Einsatz in aggressiven Umgebungen geeignet ist. Insbesondere kann das Sensormodul für den Einsatz in einem Positionssensor in Getriebesteuerungen verwendet werden oder, wie unten näher ausgeführt wird, allgemein in Schaltelementen. Auch andere Einsatzgebiete sind jedoch grundsätzlich möglich.

Bei dem vorgeschlagenen Verfahren wird mindestens ein Sensorelement auf einem Schaltungsträger, beispielsweise eine Leiterplatte, aufgebracht. Unter einem Sensorelement ist dabei im Rahmen der vorliegenden Erfindung ein Element zu verstehen, welches zur Erfassung mindestens einer physikalischen und/oder chemischen Größe geeignet ist. insbesondere kann es sich bei dem Sensorelement um ein Sensorelement handeln, welches eingerichtet ist, um elektromagnetische und/oder magnetische Felder zu erfassen. Besonders bevorzugt sind dementsprechend Hall-Sensorelemente, beispielsweise in Form integrierter Schaltkreise. So kann das Sensorelement beispielsweise ganz oder teilweise als integrierter Sensorschaltkreis und vorzugsweise als Hall-IC ausgestaltet sein. Alternativ oder zusätzlich sind jedoch auch andere Arten von Sensorelementen möglich. Zum Aufbringen des mindestens einen Sensorelements auf den mindestens einen Schaltungsträger können dabei bekannte Techniken eingesetzt werden, beispielsweise Einpresstechniken, Löttechniken oder andere Arten der Bestückungstechnik. Diese sind dem Fachmann grundsätzlich bekannt. Unter einem Schaltungsträger ist allgemein ein vorzugsweise ebenes, plattenförmiges Element zu verstehen, welches als Träger für elektronische Bauteile geeignet ist. Insbesondere kann er Schaltungsträger aus einem isolierenden Material hergestellt sein und kann eine oder mehrere fest mit diesem isolierenden Material verbundene Leiterbahn sowie ggf. ein oder mehrere Anschlusskontakte (Kontaktpads) umfassen. Als isolierendes Material kommen beispielsweise keramische Materialien und/oder Papiermaterialien und/oder Glasfasergewebe und/oder Phenolharze und/oder Epoxidharze und/oder Polyimid in Betracht. Auch andere Materialien sind jedoch grundsätzlich einsetzbar. Neben einer ebenen, plattenförmigen Geometrie, beispielsweise in Form einer rechteckförmigen, ebenen Platte, sind auch andere Geometrien einsetzbar, beispielsweise dreidimensionale Geometrien und/oder gebogene Geometrien.

Weiterhin umfasst das Verfahren mindestens einen Schritt, bei welchem mindestens ein Stanzgitter mit dem Schaltungsträger elektrisch leitend verbunden wird. Diese Verbindung kann beispielsweise, wie unten näher ausgeführt wird, durch Schweißtechniken und/oder Löttechniken und/oder Einpresstechniken erfolgen. Beispielsweise kann der Schaltungsträger zu diesem Zweck Kontaktstellen, beispielsweise Kontaktpads und/oder Kontaktbohrungen, vorsehen, an welchen die Verbindung stattfinden kann. Unter einem Stanzgitter ist dabei im Rahmen der vorliegenden Erfindung ein Element zu verstehen, welches elektrisch leitfähige Eigenschaften aufweist und welches vorzugsweise ganz oder teilweise aus einem metallischen Material hergestellt ist. Dieses Element soll, zusätzlich zu stromleitenden Eigenschaften, mechanisch tragende Eigenschaften aufweisen, also formstabil sein, zumindest unter Einwirkung seiner eigenen Gewichtskraft. Insbesondere soll die Formstabilität derart ausgeführt sein, dass das Stanzgitter zusätzlich zu seinem eigenen Gewicht noch das Gewicht des Schaltungsträgers mit dem darauf aufgebrachten Sensorelement und/oder weiteren elektronischen Komponenten tragen kann. Das Stanzgitter kann beispielsweise ein oder mehrere elektrisch voneinander getrennte oder ganz oder teilweise elektrisch miteinander verbundene Bahnen umfassen, welche als starre Anschlussleitungen dienen können. Diesbezüglich kann beispielsweise auf übliche Stanzgitter verwiesen werden, welche beispielsweise bei der Herstellung von Chipgehäusen eingesetzt werden, beispielsweise in Form von Stanzbiege-Teilen. Neben Stanztechniken können naturgemäß auch andere Techniken eingesetzt werden, um das Stanzgitter herzustellen.

Wie oben beschrieben, werden nach dem Verbinden des Stanzgitters mit dem Schaltungsträger die derart erzeugten Zwischenprodukte in der Regel in ein Thermoplastgehäuse eingelegt und mit einem Epoxidharz ausgegossen. Im Unterschied zu einem derartigen, großvolumigen Vergießen unter Einbeziehung weiterer Bauteile als Vergussform wird erfindungsgemäß vorgeschlagen, das Stanzgitter und den Schaltungsträger zumindest teilweise mit einer zumindest weitgehenden medienresistenten isolierenden Umhüllung zu ummanteln.

Unter einer zumindest weitgehenden Medienresistenz ist dabei im Rahmen der vorliegenden Erfindung eine Eigenschaft zu verstehen, bei der im Wesentlichen keine Verschlechterung der Funktionseigenschaften in einem Medium auftreten. Unter einer medienresistenten Umhüllung ist demnach zu verstehen, dass sich die Funktionseigenschaften der Umhüllung selbst und/oder des mindestens einen umhüllten Elements unter Medieneinfluss zumindest nicht wesentlich verschlechtern sollen. Insbesondere kann eine Medienresistenz auch eine zumindest weitgehende Dichtigkeit gegenüber Medien beinhalten. Unter Medien können dabei insbesondere fluide Medien verstanden werden, also gasförmige und/oder flüssige Medien, insbesondere derartige fluide Medien, die in Kraftfahrzeugen und im Umfeld von Kraftfahrzeugen auftreten. Als Beispiele sind hier natürliche und/oder synthetische Kraftstoffe, Getriebeöl (ATF), Bremsflüssigkeit, Batteriesäure, Abgase und Abgaskondensate oder Kombinationen der genannten und/oder anderer Medien im Kraftfahrzeug oder im Kraftfahrzeugumfeld zu nennen.

Unter einer Ummantelung mit einer Umhüllung ist dabei, im Gegensatz zu einem großvolumigen Verguss, ein Verfahren zu verstehen, bei welchem das entstehende Sensormodul als eigenständiges Modul handhabbar ist, vorzugsweise ohne mit weiteren Komponenten verbunden zu sein. Die Umhüllung kann beispielsweise derart ausgestaltet sein, dass das mindestens eine Sensorelement und/oder weitere elektrische Komponenten auf dem Schaltungsträger gerade vollständig bedeckt sind.

Um die Haftung zwischen der zumindest weitgehend medienresistenten Umhüllung und dem Stanzgitter und/oder dem Schaltungsträger zu verbessern, wird vorgeschlagen, das Stanzgitter und/oder den Schaltungsträger ganz oder teilweise mit einer adhäsionsfördernden Oberfläche auszugestalten. Unter einer adhäsionsfördernden Oberfläche ist dabei eine Oberfläche zu verstehen, auf welcher die zumindest weitgehend medienresistente Umhüllung eine im Vergleich zu üblichen Schaltungsträgern und/oder Stanzgittern verbesserte Haftung aufweist. Dabei kann die adhäsionsfördernde Oberfläche durch eine geeignete Auswahl von Materialien für das Stanzgitter und/oder den Schaltungsträger erfolgen und/oder es können ein oder mehrere Beschichtungen auf diesen Elementen vorgesehen sein, welche die adhäsionsfördernde Oberfläche bereitstellen. Beispiele derartiger adhäsionsfördernder Oberflächen werden unten näher beschrieben. Die mindestens eine adhäsionsfördernde Oberfläche kann insbesondere korrosionsstabil sein, insbesondere vor der Verarbeitung bzw. dem Aufbringen der Umhüllung.

Das derart hergestellte Sensormodul kann dann beispielsweise in einem oder mehreren separaten Verbindungsschritten mit weiteren Elementen verbunden werden, beispielsweise um einen Positionssensor herzustellen. So kann beispielsweise zur Herstellung des Positionssensors und/oder einer anderen Art von Schaltelement das auf diese Weise erzeugte Sensormodul durch eine kraftschlüssige und/oder formschlüssige und/oder stoffschlüssige Verbindungstechnik mit einem Gehäuse des Positionssensors verbunden werden. Zu diesem Zweck können beispielsweise an dem Sensormodul entsprechende Befestigungselemente vorgesehen sein, beispielsweise Gewindebohrungen, Bohrungen, Öffnungen, Haken oder ähnliches.

Das Ummanteln mit der isolierenden Umhüllung kann dabei derart erfolgen, dass der Schaltungsträger ganz oder teilweise von dieser Umhüllung eingeschlossen ist. Insbesondere kann die Umhüllung das mindestens eine Sensorelement bedecken. Ein oder mehrere Verbindungselemente, wie beispielsweise Bohrungen zum Befestigen des Sensormoduls an anderen Elementen, können dabei von der Umhüllung frei bleiben. Insbesondere können auch die Verbindungsstellen zwischen dem Stanzgitter und dem Schaltungsträger von der isolierenden Umhüllung ummantelt sein. Vorzugsweise ist jedoch das Stanzgitter nicht vollständig ummantelt, so dass beispielsweise ein oder mehrere Anschlusskontakte des Stanzgitters, beispielsweise in Form von "Beinchen", as der Umhüllung herausragen. Die isolierende Umhüllung kann insbesondere derart gewählt werden, dass diese eine Epoxidharzmasse umfasst. Zum Aufbringen der isolierenden Umhüllung können, insbesondere in Verbindung mit einer Epoxidharzmasse, wiederum ein Gießverfahren und/oder Pressverfahren verwendet werden, wobei besonders bevorzugt Transfermolding-Verfahren eingesetzt werden können. Unter einem Transfermolding-Verfahren ist dabei ein Verfahren zu verstehen, bei welchem eine Menge des Umhüllungsmaterials, beispielsweise ein Epoxidharzmasse und/oder ein Vorprodukt derselben, vorgeheizt wird und in eine Kammer geladen wird (auch als "Tiegel" bezeichnet, englisch "pot"). Von dort wird das fließfähige Material aus dem Tiegel mittels eines Kolbens durch Kanäle in Formnester eines Werkzeugs geleitet. Die Wände dieser Formnester werden üblicherweise über den Schmelzpunkt des Umhüllungsmaterials geheizt. Das Transfermolding ist also im vorliegenden Fall als Sonderform eines Umspritzens anzusehen, wobei jedoch nicht notwendigerweise thermoplastische Verfahren als Umhüllungsmaterial verwendet werden müssen, sondern, wie oben dargestellt, beispielsweise auch Duroplaste und/oder Elastomere, wie beispielsweise Epoxidharzmassen. Eine Aushärtung kann unmittelbar in der Form erfolgen oder beispielsweise später.

Die isolierende Umhüllung kann insbesondere derart gewählt werden, dass diese ein Material aufweist, welches eine Glasübergangstemperatur von mehr als 140°C aufweist. Die Umhüllung kann ganz oder teilweise aus diesem Material bestehen. Weiterhin kann die isolierende Umhüllung derart gewählt werden, dass diese ein Material aufweist, d.h. ganz oder teilweise aus diesem Material besteht, welches einen thermischen Ausdehnungskoeffizienten zwischen 5·10⁻⁶ 1/K und 40·10⁻⁶ 1/K aufweist, insbesondere zwischen 10·10⁻⁶ 1/K und 20·10⁻⁶ 1/K. Auf diese Weise kann, durch die bevorzugte Wahl der Glasübergangstemperatur und/oder des thermischen Ausdehnungskoeffizienten, die Umhüllung mit möglichst günstigen thermomechanischen Eigenschaften ausgestaltet werden, die insbesondere in Verbindung mit üblichen Schaltungsträgermaterialien vorteilhaft sind.

Die isolierende Umhüllung kann insbesondere ein Material aufweisen, welches mindestens ein Matrixmaterial umfasst. Als Matrixmaterial kann insbesondere ein Kunststoffmaterial gewählt werden, beispielsweise, wie oben dargestellt, ein Epoxidharz. Weiterhin kann das Material mindestens einen Füllstoff aufweisen, beispielsweise einen Füllstoff, welcher die oben beschriebenen thermomechanischen Eigenschaften gewährleistet, also insbesondere die gewünschten thermischen Ausdehnungskoeffizienten. Beispielsweise kann als Füllstoff ein keramisches Pulver verwendet werden. alternativ oder zusätzlich kann gemahlenes und/oder ungeschmolzenes Siliziumdioxid verwendet werden, insbesondere Quarz. Auch andere Arten von Füllstoffen sind jedoch grundsätzlich alternativ oder zusätzlich einsetzbar. Der Füllstoff kann in dem Matrixmaterial insbesondere mit einem Füllgrad zwischen 60 und 95 Massenprozent vorliegen, insbesondere in einem Füllgrad zwischen 80 und 90 Massenprozent. Auf diese Weise lässt sich durch eine geeignete Kombination von Matrixmaterialien, Füllstoffen und Füllgraden die oben beschriebene thermomechanische Beständigkeit gut realisieren, und es lässt sich eine gute Anpassung an die Schaltungsträgermaterialien und/oder die Stanzgittermaterialien erzielen.

Die isolierende Umhüllung kann weiterhin mindestes einen Haftvermittler aufweisen, welcher eingerichtet ist, um eine Haftung zwischen der isolierenden Umhüllung und dem Stanzgitter und/oder dem Schaltungsträger zusätzlich zu verbessern. Derartige Haftvermittler sind insbesondere aus dem Bereich der Kunststofftechnik dem Fachmann bekannt. Diese Haftvermittler können insbesondere dazu beitragen, Delaminationen zu verhindern. Eine weitere Maßnahme zur Verbesserung der Haftung der Umhüllung auf dem Schaltungsträger besteht in einer möglichst weitgehenden Vermeidung von Lötstopplacken. So werden bei der Bestückung des Schaltungsträgers, insbesondere für automatische Lötverfahren, in der Regel Lötstopplacke auf den Schaltungsträger aufgebracht, welche bewirken, dass lediglich die mit dem Lot zu benetzenden Bereiche benetzt werden. In der Regel werden derartige Lötstopplacke großflächig aufgebracht. Lötstopplacke können jedoch die Haftung mit der Umhüllung stark vermindern, da die Aufgabe derartiger Lötstopplacke gerade in einer Nicht-Benetzung besteht. Es wird daher vorgeschlagen, auf dem Schaltungsträger mindestens eine Lötstelle vorzusehen, beispielsweise eine Lötstelle zur Verbindung mit dem mindestens einen Sensorelement und/oder mit mindestens einem weiteren elektronischen Bauelement, beispielsweise mindestens einem aktiven und/oder passiven Bauelement. Insbesondere kann diese Lötstelle ein Kontaktpad umfassen. Dabei wird um die Lötstelle herum ein Lötstopplack auf den Schaltungsträger aufgebracht, jedoch nicht, wie bei bekannten Verfahren großflächig, sondern lediglich als Rahmen um die Lötstelle herum. So kann beispielsweise der Rahmen eine Breite aufweisen, welche die Abmessungen (beispielsweise den Durchmesser und/oder die Kantenlänge) der Lötstelle um nicht mehr als einen Faktor 5, vorzugsweise um einen geringeren Faktor, überschreitet. Auf diese Weise kann die Verwendung von Lötstopplack minimiert werden, und die Haftung der Umhüllung auf dem Schaltungsträger kann verbessert werden.

Wie oben beschrieben, weisen das Stanzgitter und/oder der Schaltungsträger mindestens eine adhäsionsfördernde Oberfläche auf, um die Haftung der Umhüllung zu verbessern. Diese adhäsionsfördernde Oberfläche kann beispielsweise durch eine geeignete Wahl der Materialien der Leiterbahnen auf dem Schaltungsträger und/oder der Materialien des Stanzgitters erzeugt werden. So kann der Schaltungsträger mindestens eine Leiterbahn umfassen, wobei dieser Begriff auch Anschlusskontakte umfassen soll. Diese Leiterbahn und/oder das Stanzgitter können dann vorzugsweise eines oder mehrere der folgenden Materialien aufweisen, welche die adhäsionsfördernde Oberfläche und/oder einen Teil dieser adhäsionsfördernden Oberfläche bilden: Ag, insbesondere elektrochemisch abgeschiedenes Ag ("chemisch Silber"); Ni/Ag; Ni/Pd; Ni/Pd/Au; Cu, insbesondere Cu mit einem organischen Oberflächenschutz und einen organischen Oberflächenschutz. Unter Ni/Ag bzw. Ni/Pd bzw. Ni/Pd/Au ist dabei eine Schichtfolge aus mehreren Schichten zu verstehen, welche die genannten Metalle vorzugsweise in der genannten Reihenfolge, von der zu beschichtenden Oberfläche aus betrachtet, umfasst. Unter einem organischen Oberflächenschutz (englisch: organic surface protection, OSP) ist eine organische Lösung zu verstehen, die beispielsweise durch ein Tauch- oder Spülbad selektiv auf die Oberflächen abgeschieden werden kann. Typischerweise weisen derartige organische Oberflächenschutzschichten Dicken zwischen 0,2 und 0,6 µm auf. Beispielsweise können organische Oberflächenschutzmaterialien verwendet werden, die auf substituierten Imidiazolen basieren.

Wie oben dargestellt, können bei dem Verbinden des Stanzgitters mit dem Schaltungsträger insbesondere Lötverfahren, Einpresstechniken oder Schweißverfahren eingesetzt werden oder Kombinationen der genannten und/oder anderer Verfahren. Besonders bevorzugt ist die Verwendung einer oder mehrer der folgenden Verfahren: ein Bügellöten; ein Thermodenlöten; ein Kolbenlöten, insbesondere ein maschinelles Kolbenlöten; ein Laserlöten, insbesondere ein maschinelles Laserlöten; ein Schwalllöten; ein Tiegellöten; ein Schöpflöten; eine Einpresstechnik. Das vorgeschlagene Verfahren in einer oder mehreren der oben beschriebenen Ausführungsvarianten weist gegenüber bekannten Verfahren zahlreiche Vorteile auf. Besonders vorteilhaft ist, wie oben beschrieben, die Verwendung einer Umhüllung des Schaltungsträgers durch eine Epoxidharz-Transfermolding-Masse. Eine Optimierung der Haftung der Epoxidharzmasse auf allen Oberflächen kann eine sehr gute Dichtheit des Sensorelements bewirken, was insbesondere in Positionssensoren von erheblichem Vorteil ist. Die mögliche Anpassung des Ausdehnungskoeffizienten der Epoxidharzmasse an den Ausdehnungskoeffizienten des Schaltungsträgers reduziert das Delaminationsrisiko und kann die Zuverlässigkeit der Sensorelemente, insbesondere der gelöteten Bauelemente, bei Temperaturwechseln stark erhöhen. Gegenüber vergossenen Sensorelementen, wie sie aus dem Stand der Technik bekannt sind, kann eine kleinere Außengeometrie erzielt werden, da insbesondere das Thermoplastgehäuse entfallen kann.

Neben dem vorgeschlagenen Verfahren in einer oder mehreren der oben beschriebenen Ausführungsformen wird weiterhin ein Sensormodul zum Einsatz in aggressiven Umgebungen vorgeschlagen, welches mindestens ein Sensorelement auf einem Schaltungsträger sowie mindestens ein mit dem Schaltungsträger elektrisch leitend verbundenes Stanzgitter umfasst, wobei das Stanzgitter und/oder der Schaltungsträger zumindest eine adhäsionsfördernde Oberfläche aufweisen. Weiterhin umfasst das Sensormodul mindestens eine das Stanzgitter und den Schaltungsträger zumindest teilweise ummantelnde, zumindest weitgehend medienresistente isolierende Umhüllung. Bezüglich der Begriffe der adhäsionsfördernden Oberfläche und der medienresistenten Umhüllung kann dabei auf die obige Beschreibung verwiesen werden. Das Sensormodul kann insbesondere hergestellt werden nach einem Verfahren gemäß einer oder mehreren der oben beschriebenen Ausführungsvarianten, so dass für mögliche Einzelheiten und Vorteile des erfindungsgemäßen Sensormoduls weitgehend auf die obige Beschreibung verwiesen werden kann.

Neben dem Sensormodul und dem Verfahren in einer der beschriebenen Ausführungsformen wird weiterhin ein Schaltelement vorgeschlagen. Unter einem Schaltelement ist dabei ein Element zu verstehen, welches, beispielsweise durch eine Aktion eines Benutzers und/oder einer anderen Vorrichtung, zwischen mindestens zwei, vorzugsweise mehreren, Schaltzuständen hin- und herschalten kann. Insbesondere kann dieses Schaltelement für den Einsatz in einer Getriebesteuerung eines Kraftfahrzeugs vorgesehen sein. Das Schaltelement umfasst mindestens einen Signalerzeuger, also ein Element, welches eingerichtet ist, um mindestens ein physikalisch und/oder chemisch wahrnehmbares Signal zu erzeugen. Insbesondere kann dieser mindestens eine Signalerzeuger mindestens einen elektromagnetischen oder mindestens einen magnetischen Felderzeuger umfassen, beispielsweise den im eingangs genannten Stand der Technik beschriebenen Permanentmagneten, insbesondere mit mehreren Nord-Süd-Übergängen. Weiterhin umfasst das Schaltelement mindestens ein Sensormodul gemäß der obigen Beschreibung, insbesondere herstellbar nach einem erfindungsgemäßen Verfahren gemäß einer oder mehreren der oben beschriebenen Ausführungsformen. Der Signalerzeuger und das Sensormodul sind dabei in dem Schaltelement derart aufgenommen, dass mindestens eine relative Position zwischen dem Signalerzeuger und dem Sensormodul veränderbar ist. Diese Veränderung kann beispielsweise dadurch erfolgen, dass eines oder beide der genannten Elemente auf einem Schlitten montiert sind. Beispielsweise kann eine Position in einer Dimension verändert werden. Wahlweise können auch mehrere Dimensionen veränderbar ausgestaltet sein, beispielsweise in Form einer Linearbewegung gekoppelt mit einer Kippbewegung. Für mögliche weitere Ausgestaltungen des Sensormoduls kann auf die obige Beschreibung verwiesen werden. Die dort beschriebenen Vorteile des Sensormoduls übertragen sich auch auf die Vorteile des Schaltelements gegenüber bekannten Schaltelementen.

### Kurze Beschreibung der Zeichnungen

Ausführungsbeispiele der Erfindung sind in den Zeichnungen dargestellt und in der nachfolgenden Beschreibung näher erläutert.

### Es zeigen

- Figur 1: einen bekannten Positionssensor für eine Getriebesteuerung;
- Figur 2: einen erfindungsgemäßen Positionssensor;
- Figuren 3A-3C: einen Ablaufplan eines erfindungsgemäßen Verfahrens zur Herstellung eines Positionssensors;
- Figur 4: ein Beispiel einer konventionellen Löttechnik mit vollflächiger Beschichtung durch Lötstopplack; und
- Figur 5: ein Beispiel einer im Rahmen der vorliegenden Erfindung verwendeten Löttechnik mit Reduzierung des Lötstopplacks.

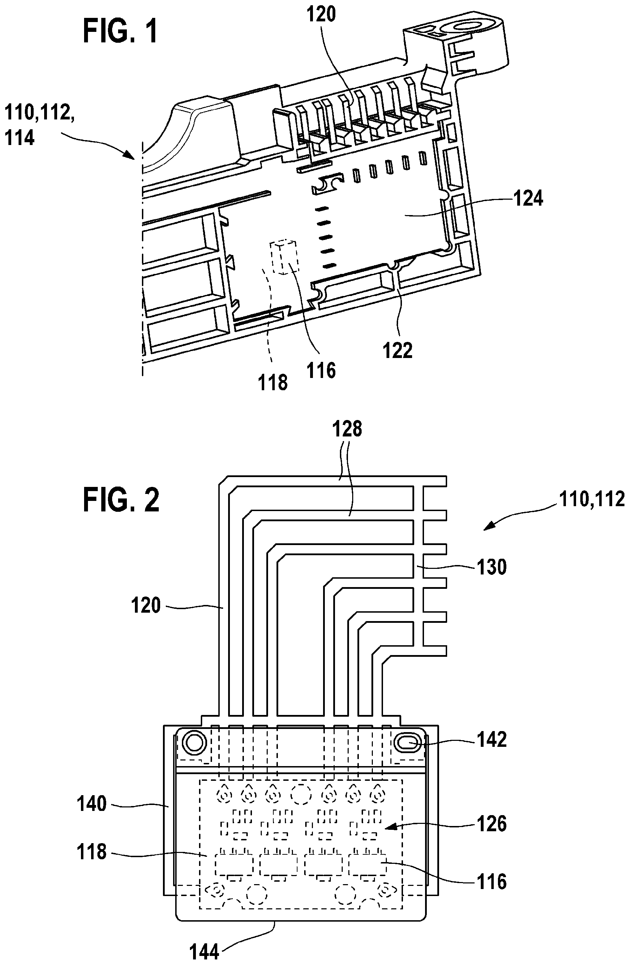

Die Erfindung wird im Folgenden am Beispiel eines Sensormoduls 110 beschrieben, welches als Positionssensor 112 ausgestaltet ist. In Fig. 1 ist ein Teil eines Schaltelements 114, wie aus dem Stand der Technik bekannt ist und wie es beispielsweise in einer Getriebesteuerung eingesetzt werden kann. Für Beispiele derartiger bekannter Schaltelemente 114 mit Positionssensoren 112 für Getriebesteuerungen kann beispielsweise auf die oben beschriebene Veröffentlichung "Elektronische Getriebesteuerung EGS", Robert Bosch GmbH, 2004, Seite 60 verweisen werden. Der bekannte Positionssensor 112 gemäß der Darstellung in Fig. 1 umfasst ein oder mehrere Sensorelemente 116, beispielsweise in Form von Hall-ICs. Diese Sensorelemente 116 sind, beispielsweise gemeinsam mit weiteren elektrischen Bauelementen, beispielsweise passiven Bauelementen, auf einen Schaltungsträger, hier in Form einer Leiterplatte 118 dargestellt, aufgebracht, werden ggf. mit einem oder mehreren Stanzgittern 120 verbunden und werden in ein Gehäuse 122, beispielsweise ein Thermoplastgehäuse, eingelegt. Anschließend werden die Hohlräume des Gehäuses 122, in welche die Leiterplatte 118 und das Stanzgitter 120 eingelegt sind, mit einer Epoxidharzmasse vergossen. In Fig. 1 ist der Verguss mit der Bezugsziffer 124 bezeichnet.

In Fig. 2 ist demgegenüber ein erfindungsgemäßes Sensormodul 110, welches ebenfalls wiederum als Positionssensor 112 ausgestaltet ist, dargestellt. Wiederum umfasst dieses Sensormodul 110 einen Schaltungsträger, welcher hier wiederum beispielhaft in Form einer Leiterplatte 118 dargestellt ist. Im Folgenden wird, ohne Beschränkung weiterer möglicher Ausgestaltungen des Schaltungsträgers, der Begriff der Leiterplatte 118 verwendet. Auf die Leiterplatte 118 sind in dem dargestellten Ausführungsbeispiel vier Sensorelemente 116 aufgebracht, wiederum beispielsweise in Form von Hall-ICs. Weiterhin können auf der Leiterplatte 118 wiederum zusätzliche elektronische Bauelemente angeordnet sein, welche in Fig. 2 allgemein mit der Bezugsziffer 126 bezeichnet sind. Dabei kann es sich wiederum beispielsweise um passive Bauelemente und/oder auch um aktive Bauelemente handeln. Weiterhin umfasst das Sensormodul 110 gemäß Fig. 2 wiederum ein Stanzgitter 120. Dieses Stanzgitter 120 ist derart ausgestaltet, dass dieses Zuleitungen 128 ("Beinchen") umfasst. Weiterhin kann das Stanzgitter 120 zusätzliche Elemente umfassen, wie beispielsweise Stege 130, welche vor Inbetriebnahme des Sensormoduls 110 auch entfernt werden können. Zudem kann das Stanzgitter 120 beispielsweise weiterhin einen Stanzgitterrahmen 140 umfassen, welcher ggf. über ein oder mehrere Befestigungselemente 142 verfügen kann, beispielsweise Bohrungen, um das Sensormodul 110 an weiteren Bauteilen zu befestigen, beispielsweise anderen Elementen des Schaltelements 114. Über diesen Stanzgitterrahmen 140 kann beispielsweise dementsprechend eine Erdung oder eine Masseverbindung des Sensormoduls 110 erfolgen. Weiterhin kann der Stanzgitterrahmen 140 die Leiterplatte 118 aufnehmen und/oder ganz oder teilweise umschließen, so dass die mechanische Stabilität durch diesen Rahmen erhöht wird.

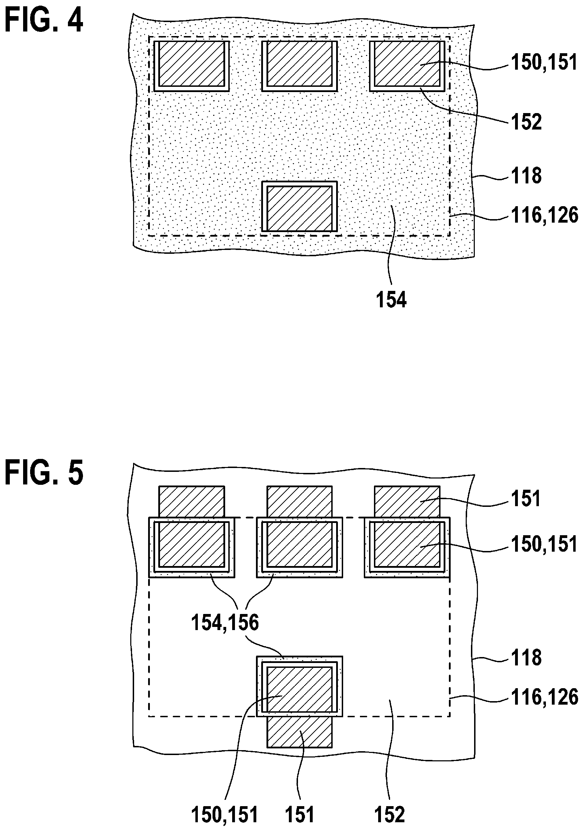

Weiterhin umfasst das Sensormodul 110 gemäß der Erfindung in dem Ausführungsbeispiel gemäß Fig. 2 eine Umhüllung 144, beispielsweise mit einer Epoxidharz-Transfermold-Masse. Wie in Fig. 4 dargestellt, ummantelt diese Umhüllung 144 in dem dargestellten Ausführungsbeispiel die Leiterplatte 118 mit den darauf aufgebrachten elektronischen Bauelementen 126 und den Sensorelementen 116 vorzugsweise vollständig. Auch das Standgitter 120 wird mit umschlossen, beispielsweise im Bereich der Verbindungen dieses Stanzgitters 120 mit der Leiterplatte 118. Diese Umhüllung 144 mittels einer Epoxidharzmasse bewirkt, dass das in Fig. 2 dargestellte Sensormodul als eigenständiges Modul gehandhabt werden kann, ohne die Notwendigkeit zusätzlicher Formen, wie beispielsweise des aus dem Stand der Technik bekannten Gehäuses 122. Das Sensormodul 110 ist also unabhängig von weiteren Komponenten handhabbar. Die Umhüllung 144 bildet ein Gehäuse, vorzugsweise aus einer Epoxidharzmasse, welche sich durch hohe Beständigkeit gegenüber Medien, insbesondere ATF, auszeichnet. Diese Umhüllung kann, wie oben beschrieben, insbesondere durch einen Transfermold-Prozess erzeugt werden, wobei die äußere Formgebung der Umhüllung 144 insbesondere durch diesen Transfermold-Prozess erfolgen kann.

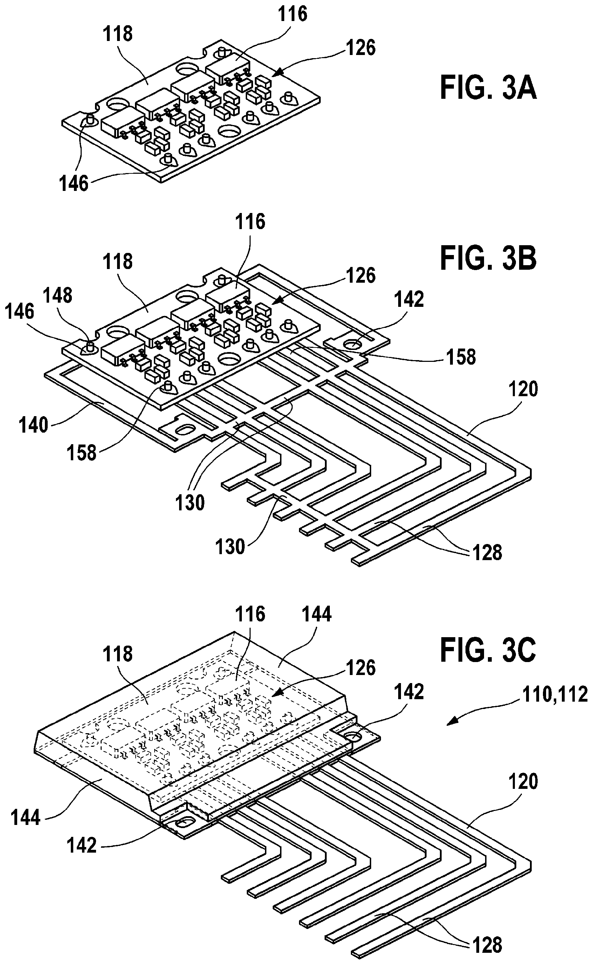

In den Fig. 3A-3C ist ein Ausführungsbeispiel eines erfindungsgemäßen Verfahrens zur Herstellung des Sensormoduls 110 gemäß Fig. 2 gezeigt. Dabei wird zunächst in einem in Fig. 3A symbolisch dargestellten Verfahrensschritt die Leiterplatte 118 mit den Sensorelementen 116 und ggf. den zusätzlichen elektronischen Bauelementen 126 bestückt. Für diese Bestückung können übliche Bestückungstechnologien verwendet werden, beispielsweise SMD-Technologien (surface mount technology, Oberflächenmontage) und/oder Durchlochkontaktierungen (THT, through hole technology). Auch Kombinationen der genannten Techniken sind möglich und/oder der Einsatz anderer Bestückungstechniken.

Die Leiterplatte 118 weist, wie in Fig. 3A erkennbar, Anschlusskontakte 146 in Form von metallisierten Bohrungen auf. In einem in Fig. 3B symbolisch dargestellten Verfahrensschritt wird das Stanzgitter 120, welches über zu den Anschlusskontakten 146 korrespondierenden Anschlüsse 148 verfügt, mit der Leiterplatte 118 verbunden. Beispielsweise kann jede der Zuleitungen 128 in einem entsprechenden Anschluss 148 münden, welcher durch die Bohrung eines entsprechenden Anschlusskontakts 146 gesteckt werden kann. Auch andere Montagetechniken sind grundsätzlich möglich. Für die elektrische Kontaktierung zwischen dem Stanzgitter 120 und der Leiterplatte 118 können geeignete, dem Fachmann bekannte Verfahren verwendet werden, beispielsweise Lötverfahren oder Schweißverfahren, insbesondere Bügellötverfahren, Thermodenlötverfahren, maschinelle Kolbenlötverfahren, maschinelle Laserlötverfahren, Schwalllötverfahren, Tiegellötverfahren, Schöpflötverfahren oder Einpresstechniken oder Kombinationen der genannten und/oder anderer Verbindungstechniken. Vorzugsweise wird ein Thermodenlötprozess verwendet.

Wie in Fig. 3B erkennbar, kann in diesem Verfahrensstadium das Stanzgitter 120 noch die Stege 130 umfassen, welche die einzelnen Zuleitungen 128 und/oder auch den Stanzgitterrahmen 140 miteinander verbinden können. In einem in den Figuren nicht dargestellten Verfahrensschritt können diese Stege 130 entfernt werden, beispielsweise nachdem das Stanzgitter 120 mit der Leiterplatte 118 verbunden ist. Alternativ oder zusätzlich können auch alle Stege 130 oder Teile dieser Stege 130 erst zu einem späteren Zeitpunkt entfernt werden, beispielsweise nach Durchführung des Verfahrensschritts in Fig. 3C. Wiederum alternativ zusätzlich können auch einige der Stege 130 im fertigen Sensormodul 110 verbleiben.

Anschließend wird in einem in Fig. 3C dargestellten Verfahrensschritt die Umhüllung 144 aufgebracht. Dies kann, wie oben beschrieben, beispielsweise durch ein Transfermolding-Verfahren erfolgen. Die Umhüllung 144, welche beispielsweise als Epoxidharzumhüllung ausgestaltet ist, überdeckt vorzugsweise die Leiterplatte 118 vollständig, so dass nur das Stanzgitter 120 aus dieser Umhüllung 144 herausragt. Wie in Fig. 3C dargestellt, können beispielsweise Befestigungselemente 142, insbesondere mit dem Stanzgitterrahmen 140 verbundene Befestigungselemente 142, und/oder Zuleitungen 128 aus der Umhüllung 144 herausragen, so dass diese Elemente ganz oder teilweise mit anderen Elementen verbindbar sind, beispielsweise zur elektrischen Kontaktierung und/oder zur mechanischen Befestigung.

Die bevorzugte Epoxidharz-Transfermoldmasse weist günstige thermomechanische Eigenschaften auf, insbesondere eine Glasübergangstemperatur oberhalb der maximalen Anwendungstemperatur von in der Regel 140°C. Weiterhin weist diese einen an den Hall-IC des Sensorelements 116, an die Leiterplatte 118 und an das Stanzgitter 120 angepassten Ausdehnungskoeffizienten von typischerweise zwischen 10·10⁻⁶ 1/K und 20·10⁻⁶ 1/K auf. Als Material für das Stanzgitter 120 werden typischerweise Metalle verwendet, beispielsweise Cu, CuSn₆ oder CuFe₂P. Zur Erzielung des bevorzugten Ausdehnungskoeffizienten der Epoxidharz-Transfermoldmase zur Herstellung der Umhüllung 144 kann beispielsweise die Epoxidharzmasse selbst als Matrixmaterial verwendet werden und mit Füllstoffen versetzt werden, beispielsweise keramischen Pulvern. Alternativ oder zusätzlich lässt sich gemahlenes und/oder umgeschmolzenes Siliziumdioxid (Quarz) verwenden. Typische Füllgrade liegen zwischen 80 und 90 Massenprozent.

Weiterhin kann die Haftung der Umhüllung 144 auf den verschiedenen, zu ummantelnden Oberflächen noch verbessert werden. So kann beispielsweise die Haftung der Epoxidharzmasse der Umhüllung 144 auf der Oberfläche der nach außen führenden Zuleitungen 128 des Stanzgitters 120 durch geeignete Additive gezielt erhöht werden. Zur Erzielung einer guten Haftung der TransfermoldMasse auf der Leiterplatte 118 lassen sich ebenfalls verschiedene Maßnahmen treffen. Die Haftung der Umhüllung 144, insbesondere einer Epoxidharzmasse, auf dem Leiterplattengrundmaterial ist im Allgemeinen sehr gut. So enthalten, wie oben dargestellt, viele Leiterplatten Grundmaterialien ohnehin Epoxide, so dass nicht nur eine gute Anpassung der thermischen Ausdehnungskoeffizienten erfolgt, sondern in der Regel auch eine gute Haftung vorliegt. Auch hier lassen sich zur Verbesserung der Haftung geeignete Additive einsetzen.

Weiterhin umfasst die Leiterplatte 118 in der Regel (in den Figuren nicht dargestellte) Leiterbahnen. Die Oberflächen dieser Leiterbahnen können, wie auch die Oberflächen des Stanzgitters 120, für eine Haftung mit der Epoxidharzmasse bzw. einer anderen Art von Umhüllungsmaterial für die Umhüllung 144 optimiert werden und ganz oder teilweise mit adhäsionsfördernden Oberflächen 158 ausgestattet werden. So kann beispielsweise zur Erzielung einer guten Haftung der Transfer-Mold-Masse auf den Leiterbahnen eine stabile, adhäsionsfördernde Oberfläche 158 eingesetzt werden, beispielsweise chemisches Silber, Nickel/Gold, Nickel/Palladium/Gold oder Kupfer, insbesondere Kupfer mit organischem Oberflächenschutz (organic surface protection, OSP). Vorzugsweise werden die Leiterbahnen ganz oder teilweise in Cu-OSP ausgeführt. Um das Eindringen von Umgebungsmedien, wie beispielsweise ATF oder anderen Medien, in die Umhüllung 144, welche das Gehäuse des Sensormoduls 110 bilden kann, zu verhindern, ist eine Verwendung derartiger adhäsionsfördernder Oberflächen 158 mit sehr guter Haftungsausbildung und sehr guter Korrosionsstabilität von Vorteil. Beispielsweise lassen sich die oben beschriebenen adhäsionsfördernden Oberflächen 158 einsetzen. Gleichzeitig sollten diese adhäsionsfördernden Oberflächen 158, beispielsweise die adhäsionsfördernden Oberflächen 158 der Leiterbahnen und/oder des Stanzgitters 120, kompatibel zu üblichen Verbindungsverfahren sein, wie beispielsweise Lötverfahren und/oder Schweißverfahren, um die elektrische Kontaktierung beispielsweise des Sensorelements 116 innerhalb der Baugruppe zu ermöglichen. Diesbezüglich haben sich insbesondere adhäsionsfördernde Oberflächen 158 mit chemischem Silber als vorteilhaft erwiesen.

Auch die Bestückungstechnik zur Bestückung der Leiterplatte 118 lässt sich dahingehend optimieren, dass später die Umhüllung 144 optimal auf der bestückten Leiterplatte 118 haftet. Eine derartige Optimierung kann beispielsweise darin bestehen, dass, zur Erzielung einer guten Haftung der Umhüllung 144, auf der Leiterplatte 118 kein Lötstopplack verwendet wird oder lediglich geringste Mengen an Lötstopplack, beispielsweise ein notwendiger Lötstopplack, welcher auf ein Minimum reduziert ist. Dies soll am Beispiel der Figuren 4 und 5 erläutert werden. Die Figuren 4 und 5 zeigen jeweils einen Ausschnitt der Leiterplatte 118, auf welcher ein elektronisches Bauelement 126 und/oder ein Sensorelement 116 bestückt werden soll. Dieses elektronische Bauelement 126 bzw. das Sensorelement 116 ist in den Figuren 4 und 5 symbolisch durch einen gestrichelten, rechteckigen Rahmen angedeutet. Bei dieser Bestückung bzw. Kontaktierung sollen auf Lötstellen 150 entsprechende Anschlüsse der Sensorelemente 116 bzw. der weiteren elektronischen Bauelemente 126 aufgebracht werden. In den Figuren 4 und 5 sind Leiterbahnen symbolisch mit der Bezugsziffer 151 bezeichnet. Die Lötstellen 150 bilden in diesem Fall die äußersten Bereiche dieser Leiterbahnen 151. Auch eine andere Ausgestaltung der Lötstellen 150 ist jedoch grundsätzlich möglich, beispielsweise in Form von freistehenden, nicht mit Leiterbahnen 151 verbundenen Anschluss-Pads. Zum Zweck des Aufbringens und Verbindens der Anschlüsse der Sensorelemente 116 und/oder der weiteren elektronischen Bauelemente 126 werden die Lötstellen 150 durch entsprechende Verfahren mit Lot beschichtet, beispielsweise durch Tauchverfahren und/oder Schwallverfahren. Die Lötstellen 150 sind dabei in vielen Fällen mit zinnhaltigen Oberflächen versehen, beispielsweise chemischem Zinn und/oder HASL (hot air solder leveling). Derartige Standardbeschichtungen sind dem Fachmann bekannt. Die Lötstellen 150 können insbesondere, auch zusammen mit anderen freiliegenden Leiterbahnen 151, ganz oder teilweise in Cu-OSP ausgeführt sein. Dabei wird in der Regel, wie in dem in Fig. 4 dargestellten, bekannten Verfahren, auf das Grundmaterial 152 der Leiterplatte 118 vollflächig ein Lötstopplack 154 aufgebracht, so dass dieser lediglich die Lötstellen 150 freilässt, sowie ggf. einen schmalen Bereich mit freiliegendem Grundmaterial 152 um diese Lötstellen 150 herum. Der Lötstopplack verhindert dann beim Benetzen mit Lot, dass das Lot sich über die Lötstellen 150 hinaus ausbreitet.

Erfindungsgemäß wurde jedoch erkannt, dass dieser Lötstopplack 150 die Haftung der Leiterplatte 118 mit der Umhüllung 144 vermindern kann. Daher ist in Fig. 5 ein Verfahrensaspekt der Bestückung dargestellt, bei welchem die Verwendung von Lötstopplack 154 auf ein Minimum reduziert ist. Zu diesem Zweck erfolgt dort keine großflächige Beschichtung mit Lötstopplack 154, sondern es wird jeweils um die Lötstellen 150 herum ein Rahmen 156 an Lötstopplack 154 aufgebracht, welcher eine Ausbreitung des Lotes verhindert. Die Dimensionen dieses Rahmens 156 können klein gehalten werden, so dass die Haftung mit der Umhüllung 144 verbessert werden kann. Die Rahmen 156 können beispielsweise von ihren inneren Abmessungen her den äußeren Abmessungen der Lötstellen 150 folgen, wobei wiederum, wie auch in Fig. 4, ein kleiner Rand an freiliegendem Grundmaterial 152 zwischen den Rahmen 156 und den Lötstellen 150 verbleiben kann. Die Breite der Rahmen sollte dabei möglichst klein gehalten werden, um einerseits noch ein Ausbreiten von Lot hin zu anderen Lötstellen 150 und damit die Ausbildung von Kurzschlüssen zu verhindern und gleichzeitig noch eine so geringe Fläche wie möglich zu bieten. Die Rahmen 156 lassen sich beispielsweise durch entsprechende Drucktechniken herstellen.

Insgesamt lässt sich durch das in den Fig. 3A-3C und in der Fig. 5 beschriebene Verfahren somit ein Sensormodul 110 herstellen, insbesondere ein Positionssensor, welcher den oben genannten Anforderungen hinsichtlich der thermischen Beständigkeit und der Mediendichtigkeit hervorragend genügt. Insbesondere wird durch die sehr gute Haftung der Umhüllung 144, beispielsweise der Epoxidharzmasse, auf der adhäsionsfördernden Oberfläche 158 des Stanzgitters 120 das Eindringen von Medien vollständig verhindert. Auf diese Weise lässt sich ein separat handhabbares, kleinvolumiges Sensormodul 110 auch als Zwischenprodukt herstellen, welches beispielsweise separat bevorratet werden kann, und welches erst in einem anschließenden Schritt mit übrigen Bauteilen des Schaltelements 114 verbunden werden kann.

## Patentansprüche

1. Verfahren zur Herstellung eines Sensormoduls (110), insbesondere eines zumindest weitgehend mediendichten Sensormoduls (110), zum Einsatz in aggressiven Umgebungen, wobei mindestens ein Sensorelement (116) auf einen Schaltungsträger (118) aufgebracht wird, wobei mindestens ein Stanzgitter (120) mit dem Schaltungsträger (118) elektrisch leitend verbunden wird, wobei das Stanzgitter (120) und der Schaltungsträger (118) zumindest teilweise mit einer zumindest weitgehend medienresistenten isolierenden Umhüllung (144) ummantelt werden, wobei auf dem Schaltungsträger (118) mindestens eine Leiterbahn (151) vorgesehen ist, **dadurch gekennzeichnet, dass**
das Stanzgitter (120) und/oder der Schaltungsträger (118) zumindest eine adhäsionsfördernde Oberfläche (158) aufweisen, und dass die Leiterbahn (151) eine oder mehrere der folgenden adhäsionsfördernden Oberflächen (158) aufweist: Ag; Ni/Ag; Ni/Pd; Ni/Pd/Au; Cu; einen organischen Oberflächenschutz, wobei das Stanzgitter (120) eine oder mehrere der folgenden adhäsionsfördernden Oberflächen (158) aufweist: Ag; elektrochemisch abgeschiedenes Ag; Ni/Ag; Ni/Pd; Ni/Pd/Au, wobei zum Aufbringen der isolierenden Umhüllung (144) ein Transfermolding-Verfahren verwendet wird, wobei auf dem Schaltungsträger (118) mindestens eine Lötstelle (150) vorgesehen ist, wobei um die Lötstelle (150) ein Lötstopplack (154) auf dem Schaltungsträger (118) aufgebracht wird, wobei der Lötstopplack (154) als Rahmen (156) um die Lötstelle (150) aufgebracht wird.

2. Verfahren nach dem vorhergehenden Anspruch, wobei die Leiterbahn (151) eine oder mehrere der folgenden adhäsionsfördernden Oberflächen (158) aufweist: elektrochemisch abgeschiedenes Ag; Cu mit einem organischen Oberflächenschutz.

3. Verfahren nach einem der vorhergehenden Ansprüche, wobei das Stanzgitter (120) elektrochemisch abgeschiedenes Ag als adhäsionsfördernde Oberfläche (158) aufweist.

4. Verfahren nach einem der vorhergehenden Ansprüche, wobei die Lötstelle (150) ein Kontaktpad umfasst.

5. Verfahren nach einem der vorhergehenden Ansprüche, wobei die isolierende Umhüllung (144) derart gewählt wird, dass diese eine Epoxidharzmasse umfasst.

6. Verfahren nach einem der vorhergehenden Ansprüche, wobei die isolierende Umhüllung (144) derart gewählt wird, dass diese ein Material aufweist, welches eine Glasübergangstemperatur von mehr als 140°C aufweist.

7. Verfahren nach einem der vorhergehenden Ansprüche, wobei die isolierende Umhüllung (144) derart gewählt wird, dass diese ein Material aufweist, welches einen thermischen Ausdehnungskoeffizienten zwischen 5·10⁻⁶ 1/K und 40·10⁻⁶ 1/K aufweist, insbesondere zwischen 10·10⁻⁶ 1/K und 20·10⁻⁶ 1/K.

8. Verfahren nach einem der vorhergehenden Ansprüche, wobei die isolierende Umhüllung (144) derart gewählt wird, dass diese mindestens einen Haftvermittler aufweist, wobei der Haftvermittler eingerichtet ist, um eine Haftung zwischen der isolierenden Umhüllung (144) und dem Stanzgitter (120) und/oder dem Schaltungsträger (118) zu verbessern.

9. Sensormodul (110) zum Einsatz in aggressiven Umgebungen, insbesondere herstellbar nach einem Verfahren gemäß einem oder mehreren der vorhergehenden Ansprüche, umfassend mindestens ein Sensorelement (116), insbesondere einen integrierten Sensorschaltkreis und vorzugsweise einen Hall-IC, auf einem Schaltungsträger (118), weiterhin umfassend mindestens ein mit dem Schaltungsträger (118) elektrisch leitend verbundenes Stanzgitter (120), weiterhin umfassend mindestens eine das Stanzgitter (120) und den Schaltungsträger (118) zumindest teilweise ummantelnde, zumindest weitgehend medienresistente isolierende Umhüllung (144), wobei auf dem Schaltungsträger (118) mindestens eine Leiterbahn (151) vorgesehen ist, **dadurch gekennzeichnet, dass**
das Stanzgitter (120) und/oder der Schaltungsträger (118) zumindest eine adhäsionsfördernde Oberfläche (158) aufweisen, und dass die Leiterbahn (151) eine oder mehrere der folgenden adhäsionsfördernden Oberflächen (158) aufweist: Ag; Ni/Ag; Ni/Pd; Ni/Pd/Au; Cu; einen organischen Oberflächenschutz, wobei das Stanzgitter (120) eine oder mehrere der folgenden adhäsionsfördernden Oberflächen (158) aufweist: Ag; Ni/Ag; Ni/Pd; Ni/Pd/Au, wobei die isolierende Umhüllung (144) mittels eines Transfermolding-Verfahrens aufgebracht ist, wobei auf dem Schaltungsträger (118) mindestens eine Lötstelle (150) vorgesehen ist, wobei um die Lötstelle (150) ein Lötstopplack (154) auf dem Schaltungsträger (118) aufgebracht ist, wobei der Lötstopplack (154) als Rahmen (156) um die Lötstelle (150) aufgebracht ist.

10. Schaltelement (114), insbesondere für den Einsatz in einer Getriebesteuerung eines Kraftfahrzeugs, umfassend mindestens einen Signalerzeuger, insbesondere einen elektromagnetischen und/oder magnetischen Felderzeuger, weiterhin umfassend mindestens ein Sensormodul (110) nach dem vorhergehenden Anspruch, wobei der Signalerzeuger und das Sensormodul (110) in dem Schaltelement derart aufgenommen sind, dass mindestens eine relative Position zwischen dem Signalerzeuger und dem Sensormodul (110) veränderbar ist.

## Claims

1. Method for producing a sensor module (110), in particular an at least largely media-proof sensor module (110), for use in aggressive environments, wherein at least one sensor element (116) is applied to a circuit carrier (118), wherein at least one leadframe (120) is electrically conductively connected to the circuit carrier (118), wherein the leadframe (120) and the circuit carrier (118) are at least partly enveloped with an at least largely media-resistant insulating encapsulation (144), wherein at least one conductor track (151) is provided on the circuit carrier (118), **characterized in that** the leadframe (120) and/or the circuit carrier (118) have/has at least one adhesion-promoting surface (158), and **in that** the conductor track (151) has one or more of the following adhesion-promoting surfaces (158): Ag; Ni/Ag; Ni/Pd; Ni/Pd/Au; Cu; an organic surface protection, wherein the leadframe (120) has one or more of the following adhesion-promoting surfaces (158): Ag; electrochemically deposited Ag; Ni/Ag; Ni/Pd; Ni/Pd/Au, wherein a transfer moulding method is used for applying the insulating encapsulation (144), wherein at least one soldering location (150) is provided on the circuit carrier (118), wherein a soldering resist (154) is applied on the circuit carrier (118) around the soldering location (150), wherein the soldering resist (154) is applied as a frame (156) around the soldering location (150).

2. Method according to the preceding claim, wherein the conductor track (151) has one or more of the following adhesion-promoting surfaces (158): electrochemically deposited Ag; Cu with an organic surface protection.

3. Method according to either of the preceding claims, wherein the leadframe (120) has electrochemically deposited Ag as an adhesion-promoting surface (158).

4. Method according to any of the preceding claims, wherein the soldering location (150) comprises a contact pad.

5. Method according to any of the preceding claims, wherein the insulating encapsulation (144) is chosen in such a way that it comprises an epoxy resin composition.

6. Method according to any of the preceding claims, wherein the insulating encapsulation (144) is chosen in such a way that it comprises a material having a glass transition temperature above more than 140°C.

7. Method according to any of the preceding claims, wherein the insulating encapsulation (144) is chosen in such a way that it comprises a material having a coefficient of thermal expansion of between 5·10⁻⁶ 1/K and 40·10⁻⁶ 1/K, in particular between 10·10⁻⁶ 1/K and 20·10⁻⁶ 1/K.

8. Method according to any of the preceding claims, wherein the insulating encapsulation (144) is chosen in such a way that it comprises at least one adhesion promotor, wherein the adhesion promoter is configured to improve an adhesion between the insulating encapsulation (144) and the leadframe (120) and/or the circuit carrier (118).

9. Sensor module (110) for use in aggressive environments, in particular producible according to a method according to one or more of the preceding claims, comprising at least one sensor element (116), in particular an integrated sensor circuit and preferably a Hall IC, on a circuit carrier (118), furthermore comprising at least one leadframe (120) electrically conductively connected to the circuit carrier (118), furthermore comprising at least one at least largely media-resistant insulating encapsulation (144) at least partly enveloping the leadframe (120) and the circuit carrier (118), wherein at least one conductor track (151) is provided on the circuit carrier (118), **characterized in that** the leadframe (120) and/or the circuit carrier (118) have/has at least one adhesion-promoting surface (158), and **in that** the conductor track (151) has one or more of the following adhesion-promoting surfaces (158): Ag; Ni/Ag; Ni/Pd; Ni/Pd/Au; Cu; an organic surface protection, wherein the leadframe (120) has one or more of the following adhesion-promoting surfaces (158): Ag; Ni/Ag; Ni/Pd; Ni/Pd/Au, wherein the insulating encapsulation (144) is applied by means of a transfer moulding method, wherein at least one soldering location (150) is provided on the circuit carrier (118), wherein a soldering resist (154) is applied on the circuit carrier (118) around the soldering location (150), wherein the soldering resist (154) is applied as a frame (156) around the soldering location (150).

10. Switching element (114), in particular for use in a transmission controller of a motor vehicle, comprising at least one signal generator, in particular an electromagnetic and/or magnetic field generator, furthermore comprising at least one sensor module (110) according to the preceding claim, wherein the signal generator and the sensor module (110) are accommodated in the switching element in such a way that at least one relative position between the signal generator and the sensor module (110) is variable.

## Revendications

1. Procédé de fabrication d'un module capteur (110), notamment d'un module capteur (110) au moins en grande partie étanche aux fluides, destiné à être utilisé dans des environnements agressifs, au moins un élément capteur (116) étant appliqué sur un porte-circuit (118), au moins une grille de connexion (120) étant reliée de manière électriquement conductrice au porte-circuit (118),
la grille de connexion (120) et le porte-circuit (118) étant enveloppés avec une enveloppe isolante (144) au moins en grande partie résistante aux fluides, au moins une piste conductrice (151) se trouvant sur le porte-circuit (118), **caractérisé en ce que** la grille de connexion (120) et/ou le porte-circuit (118) possèdent au moins une surface (158) favorisant l'adhérence et **en ce que** la piste conductrice (151) possède une ou plusieurs des surfaces (158) favorisant l'adhérence suivantes : Ag ; Ni/Ag ; Ni/Pd ; Ni/Pd/Au ; Cu ; une protection de surface organique, la grille de connexion (120) possédant une ou plusieurs des surfaces (158) favorisant l'adhérence suivantes : Ag ; Ag déposé par procédé électrochimique ; Ni/Ag ; Ni/Pd ; Ni/Pd/Au, un procédé de moulage par transfert étant utilisé pour déposer l'enveloppe isolante (144), au moins un point de brasage (150) se trouvant sur le porte-circuit (118), un vernis épargne de brasage (154) étant appliqué sur le porte-circuit (118) autour du point de brasage (150), le vernis épargne de brasage (154) étant appliqué sous la forme d'un cadre (156) autour du point de brasage (150).

2. Procédé selon la revendication précédente, la piste conductrice (151) possédant une ou plusieurs des surfaces (158) favorisant l'adhérence suivantes : Ag déposé par procédé électrochimique ; Cu avec une protection de surface organique.

3. Procédé selon l'une des revendications précédentes, la grille de connexion (120) possédant de l'Ag déposé par procédé électrochimique en tant que surface (158) favorisant l'adhérence.

4. Procédé selon l'une des revendications précédentes, le point de brasage (150) comportant une pastille de contact.

5. Procédé selon l'une des revendications précédentes, l'enveloppe isolante (144) étant choisie de telle sorte que celle-ci comprend une masse de résine époxy.

6. Procédé selon l'une des revendications précédentes, l'enveloppe isolante (144) étant choisie de telle sorte que celle-ci possède un matériau qui présente une température de transition vitreuse supérieure à 140 °C.

7. Procédé selon l'une des revendications précédentes, l'enveloppe isolante (144) étant choisie de telle sorte que celle-ci possède un matériau qui présente un coefficient de dilatation thermique entre 5·10⁻⁶ 1/K et 40·10⁻⁶ 1/K, notamment entre 10·10⁻⁶ 1/K et 20·10⁻⁶ 1/K.

8. Procédé selon l'une des revendications précédentes, l'enveloppe isolante (144) étant choisie de telle sorte que celle-ci possède au moins un agent adhésif, l'agent adhésif étant conçu pour améliorer une adhérence entre l'enveloppe isolante (144) et la grille de connexion (120) et/ou le porte-circuit (118).

9. Module capteur (110) destiné à être utilisé dans des environnements agressifs, pouvant notamment être fabriqué conformément à un procédé selon une ou plusieurs des revendications précédentes, comprenant au moins un élément capteur (116), notamment un circuit capteur intégré, et de préférence un circuit intégré à effet Hall, sur un porte-circuit (118), comprenant en outre au moins une grille de connexion (120) reliée de manière électriquement conductrice au porte-circuit (118), comprenant en outre au moins une enveloppe isolante (144) au moins en grande partie résistante aux fluides qui enveloppe au moins partiellement la grille de connexion (120) et le porte-circuit (118), au moins une piste conductrice (151) se trouvant sur le porte-circuit (118), **caractérisé en ce que** la grille de connexion (120) et/ou le porte-circuit (118) possèdent au moins une surface (158) favorisant l'adhérence et **en ce que** la piste conductrice (151) possède une ou plusieurs des surfaces (158) favorisant l'adhérence suivantes : Ag ; Ni/Ag ; Ni/Pd ; Ni/Pd/Au ; Cu ; une protection de surface organique, la grille de connexion (120) possédant une ou plusieurs des surfaces (158) favorisant l'adhérence suivantes : Ag ; Ni/Ag ; Ni/Pd ; Ni/Pd/Au, l'enveloppe isolante (144) étant déposée au moyen d'un procédé de moulage par transfert, au moins un point de brasage (150) se trouvant sur le porte-circuit (118), un vernis épargne de brasage (154) étant appliqué sur le porte-circuit (118) autour du point de brasage (150), le vernis épargne de brasage (154) étant appliqué sous la forme d'un cadre (156) autour du point de brasage (150).

10. Élément de commutation (114), notamment pour une utilisation dans une commande de boîte de vitesses d'un véhicule automobile, comprenant au moins un générateur de signaux, notamment un générateur de champ électromagnétique et/ou magnétique, comprenant en outre au moins un module capteur (110) selon la revendication précédente, le générateur de signaux et le module capteur (110) étant accueillis dans l'élément de commutation de telle sorte qu'au moins une position relative entre le générateur de signaux et le module capteur (110) peut être modifiée.
